# EUROPEAN PATENT APPLICATION

(11) **EP 4 489 075 A1**
(43) Date of publication of application: **08.01.2025**
(21) Application number: 23759502.0
(22) Date of filing: 12.01.2023
(51) Int. Cl.: H01L 27/146, H04N 25/76

(54) **IMAGING DEVICE**

(30) Priority: 28.02.2022 JP 2022030429
(71) Applicant: Sony Semiconductor Solutions Corporation, Atsugi-shi, Kanagawa 243-0014 (JP)
(72) Inventor: OZAKI, Kosuke, Kikuchi-gun, Kumamoto 869-1102 (JP); NISHI, Sachio, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2023/000655
(87) International publication number: WO 2023/162496

(57) **Abstract**

An imaging device according to an embodiment of the present disclosure includes: a light receiving section provided with a plurality of pixels including photoelectric converters that photoelectrically convert light; and a plurality of lenses provided on a whole surface of the light receiving section. Each of the plurality of lenses is provided with respect to at least two of the plurality of pixels and faces four of the plurality of lenses.

## Description

### Technical Field

The present disclosure relates to an imaging device.

### Background Art

An imaging device is proposed that includes a shared on-chip lens formed covering two phase-difference detection pixels (PTL 1).

### Citation List

### Patent Literature

PTL 1: International Publication No. WO2016/098640

### Summary of the Invention

Imaging devices are desired to suppress a difference in characteristic between pixels.

It is desired to provide an imaging device that makes it possible to suppress a difference in characteristic between pixels.

An imaging device according to an embodiment of the present disclosure includes: a light receiving section provided with a plurality of pixels including photoelectric converters that photoelectrically convert light; and a plurality of lenses provided on a whole surface of the light receiving section. Each of the plurality of lenses is provided with respect to at least two of the plurality of pixels and faces four of the plurality of lenses.

### Brief Description of Drawing

[FIG. 1] FIG. 1 is a block diagram illustrating an example of a schematic configuration of an imaging device according to an embodiment of the present disclosure.
[FIG. 2] FIG. 2 is a diagram illustrating an example of a pixel section of the imaging device according to the embodiment of the present disclosure.
[FIG. 3] FIG. 3 is a diagram illustrating an arrangement example of pixels of the imaging device according to the embodiment of the present disclosure.
[FIG. 4] FIG. 4 is a diagram illustrating an example of a cross-sectional configuration of the imaging device according to the embodiment of the present disclosure.
[FIG. 5] FIG. 5 is a diagram illustrating an example of a cross-sectional configuration of the imaging device according to the embodiment of the present disclosure.
[FIG. 6] FIG. 6 is a diagram illustrating another example of the cross-sectional configuration of the imaging device according to the embodiment of the present disclosure.
[FIG. 7] FIG. 7 is a diagram illustrating another example of the cross-sectional configuration of the imaging device according to the embodiment of the present disclosure.
[FIG. 8] FIG. 8 is a diagram illustrating another example of the cross-sectional configuration of the imaging device according to the embodiment of the present disclosure.
[FIG. 9] FIG. 9 is a diagram illustrating another example of the cross-sectional configuration of the imaging device according to the embodiment of the present disclosure.
[FIG. 10] FIG. 10 is a diagram illustrating another arrangement example of pixels of the imaging device according to the embodiment of the present disclosure.
[FIG. 11] FIG. 11 is a diagram illustrating another arrangement example of pixels of the imaging device according to the embodiment of the present disclosure.
[FIG. 12] FIG. 12 is a diagram illustrating another arrangement example of pixels of the imaging device according to the embodiment of the present disclosure.
[FIG. 13] FIG. 13 is a diagram illustrating an arrangement example of pixels of an imaging device according to Modification 1 of the present disclosure.
[FIG. 14] FIG. 14 is a diagram illustrating another arrangement example of pixels of the imaging device according to Modification 1 of the present disclosure.
[FIG. 15] FIG. 15 is a diagram illustrating another arrangement example of pixels of the imaging device according to Modification 1 of the present disclosure.
[FIG. 16] FIG. 16 is a diagram illustrating an arrangement example of pixels of an imaging device according to Modification 2 of the present disclosure.
[FIG. 17] FIG. 17 is a diagram illustrating another arrangement example of pixels of the imaging device according to Modification 2 of the present disclosure.
[FIG. 18] FIG. 18 is a diagram illustrating an arrangement example of pixels of an imaging device according to Modification 3 of the present disclosure.
[FIG. 19] FIG. 19 is a diagram illustrating another arrangement example of pixels of the imaging device according to Modification 3 of the present disclosure.
[FIG. 20] FIG. 20 is a diagram illustrating another arrangement example of pixels of the imaging device according to Modification 3 of the present disclosure.
[FIG. 21] FIG. 21 is a diagram illustrating an example of a cross-sectional configuration of an imaging device according to Modification 4 of the present disclosure.
[FIG. 22] FIG. 22 is a diagram illustrating an example of a cross-sectional configuration of the imaging device according to Modification 4 of the present disclosure.
[FIG. 23] FIG. 23 is a diagram illustrating an example of a cross-sectional configuration of the imaging device according to Modification 4 of the present disclosure.
[FIG. 24] FIG. 24 is a diagram illustrating an example of a cross-sectional configuration of the imaging device according to Modification 4 of the present disclosure.
[FIG. 25] FIG. 25 is a block diagram illustrating a configuration example of an electronic apparatus including the imaging device.
[FIG. 26] FIG. 26 is a block diagram depicting an example of schematic configuration of a vehicle control system.
[FIG. 27] FIG. 27 is a diagram of assistance in explaining an example of installation positions of an outside-vehicle information detecting section and an imaging section.
[FIG. 28] FIG. 28 is a view depicting an example of a schematic configuration of an endoscopic surgery system.
[FIG. 29] FIG. 29 is a block diagram depicting an example of a functional configuration of a camera head and a camera control unit (CCU).

### Modes for Carrying Out the Invention

In the following, embodiments of the present disclosure will be described in detail with reference to the drawings. Note that the description will be given in the following order.
1. Embodiments
2. Modifications
3. Examples of Application
4. Applications

### <1. Embodiments>

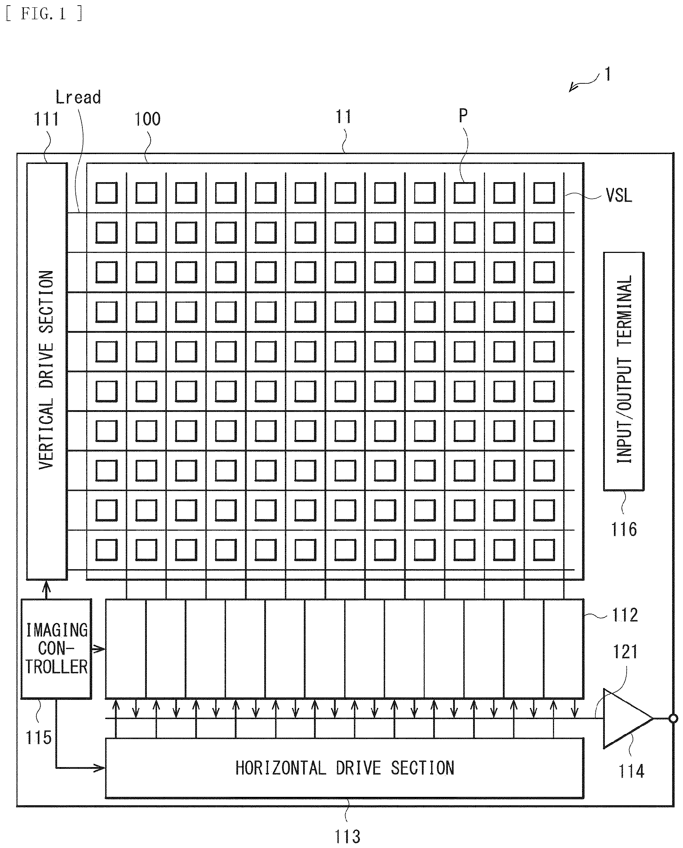

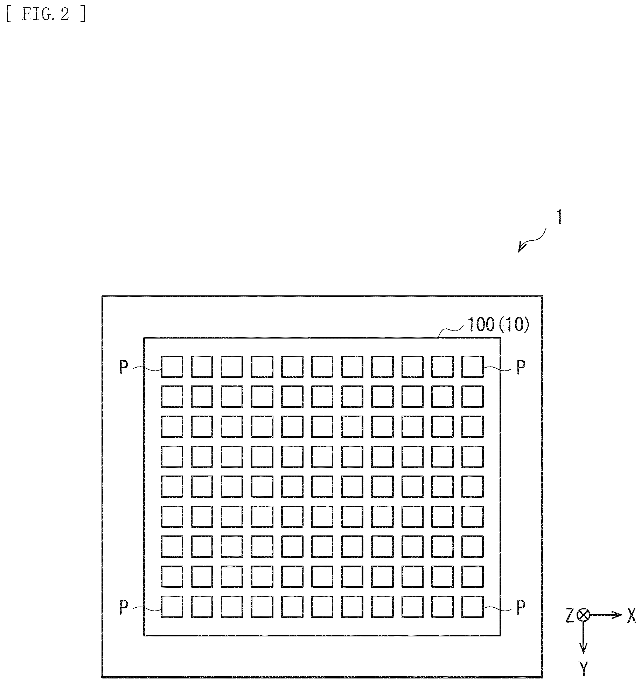

FIG. 1 is a block diagram illustrating an example of a schematic configuration of an imaging device according to an embodiment of the present disclosure. FIG. 2 is a diagram illustrating an example of a pixel section of the imaging device according to the embodiment. In an imaging device 1, pixels P each including a photoelectric converter are arranged in a matrix. As illustrated in FIG. 2, the imaging device 1 includes, as an imaging area, a region (pixel section 100) with the plurality of pixels P two-dimensionally arranged in a matrix.

The imaging device 1 captures incident light (image light) from a subject, via an optical lens system (not illustrated). The imaging device 1 captures an image of the subject, the image formed by the optical lens system. The imaging device 1 photoelectrically converts received light to generate a pixel signal. The imaging device 1 is possible to be used for an electronic apparatus such as a digital still camera, a video camera, or a mobile phone. Note that, as illustrated in FIG. 2, an incident direction of light from the subject is referred to as a Z axis direction, a lateral direction of the paper sheet orthogonal to the Z axis direction is referred to as an X axis direction, and a longitudinal direction of the paper sheet orthogonal to the Z axis direction and X axis direction is referred to as a Y axis direction. Hereinafter, in the drawings, a direction may be described based on the directions of arrows in FIG. 2 as a reference.

### [Schematic Configuration of Imaging Device]

As the example illustrated in FIG. 1, the imaging device 1 includes, in a region around the pixel section 100, a vertical drive section 111, a signal processor 112, a horizontal drive section 113, an output section 114, an imaging controller 115, and an input/output terminal 116, for example.

The imaging device 1 is provided with, for example, a plurality of pixel drive lines Lread and a plurality of vertical signal lines VSL. For example, in the pixel section 100, the plurality of pixel drive lines Lread are wired for respective pixel rows, each of the pixel rows including a plurality of pixels P arranged in a horizontal direction (row direction). Further, in the pixel section 100, the plurality of vertical signal lines VSL are wired for respective pixel columns, each of the pixel columns including a plurality of pixels P arranged in ae vertical direction (column direction). Each of the pixel drive lines Lread is configured to transmit a drive signal to be used for reading of a signal from a pixel P. Each of the vertical signal lines VSL is configured to transmit a signal output from a pixel P.

The vertical drive section 111 includes a shift register, an address decoder, and the like. The vertical drive section 111 is configured to drive each of the pixels P of the pixel section 100. The vertical drive section 111, which is a pixel drive section, generates a signal to be used for driving of a pixel P and outputs the signal to each of the pixels P of the pixel section 100 via the pixel drive lines Lread. The vertical drive section 111 generates, for example, a signal to be used for controlling of a transfer transistor and a signal to be used for controlling of a reset transistor and supplies such signals to each of the pixels P by the pixel drive lines Lread.

The signal processor 112 is configured to perform signal processing on a signal of pixel that is input. The signal processor 112 includes, for example, a load circuit section coupled to the vertical signal lines VSL, analog-digital converters (ADCs) provided for the respective vertical signal lines VSL, and horizontal selection switches. The load circuit section and amplification transistors of the pixels P constitute a source follower circuit. Note that the signal processor 112 may include an amplifier circuit section configured to amplify signals read from the pixels P via the vertical signal lines VSL.

Signals output from the pixels P selectively scanned by the vertical drive section 111 are supplied to the signal processor 112 through the vertical signal lines VSL. For example, the signal processor 112 performs signal processing such as analog-digital (AD) conversion or correlated double sampling (CDS).

The horizontal drive section 113 includes a shift register, an address decoder, and the like. The horizontal drive section 113 is configured to drive the horizontal selection switches of the signal processor 112. The horizontal drive section 113 drives the respective horizontal selection switches of the signal processor 112 in order, while scanning the horizontal selection switches. With respect to signals of the pixels P transmitted through the respective vertical signal lines VSL, signal processing is performed by the signal processor 112, and the signals are, by selective scanning by the horizontal drive section 113, output to a horizontal signal line 121 in order.

The output section 114 is configured to perform signal processing on a signal that is input and output the signal. The output section 114 performs signal processing on signals of the pixels that are input in order from the signal processor 112 via the horizontal signal line 121, and outputs the signals after the processing. For example, the output section 114 may perform only buffering or may perform black level adjustment, column unevenness correction, various digital signal processing, and the like.

A circuit portion including the vertical drive section 111, the signal processor 112, the horizontal drive section 113, the horizontal signal line 121, and the output section 114 may be formed on a semiconductor substrate 11 or may be provided on an external control IC. Further, such a circuit portion may be formed on another substrate coupled by a cable or the like.

The imaging controller 115 is configured to control each section of the imaging device 1. The imaging controller 115 receives a clock provided from the outside of the semiconductor substrate 11, data of a command for an operation mode, or the like, and also outputs data such as internal information of the imaging device 1. The imaging controller 115 includes a timing generator that generates various timing signals. The imaging controller 115 performs, on the basis of such various timing signals generated by the timing generator, drive control on a peripheral circuit such as the vertical drive section 111, the signal processor 112, or the horizontal drive section 113. The input/output terminal 116 exchanges a signal with the outside.

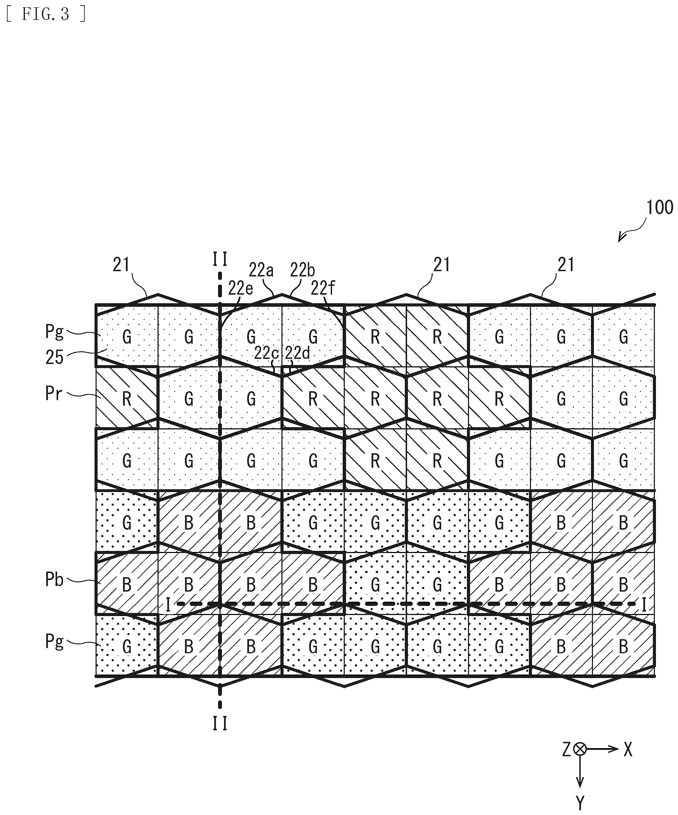

FIG. 3 is a diagram illustrating an arrangement example of pixels of the imaging device according to the embodiment. The pixels P of the imaging device 1 includes lens sections 21 that collect light and color filters 25. The lens sections 21 are optical members also called on-chip lenses.

The lens sections 21 are provided on a whole surface of the pixel section 100. Each of the lens sections 21 is provided with respect to at least two of the pixels P. Each of the lens sections 21 is arranged over at least two of the pixels P. Each of the lens sections 21 is, in other words, formed covering at least two of the pixels P. In a surface of the pixel section 100, each of the lens sections 21 is arranged facing at least four of the lens sections 21. Each of the lens sections 21 is, in the XY plane, arranged adjacent to at least four of the lens sections 21. In the present embodiment, each of the lens sections 21 is provided upper than the color filters 25, for each two of the pixels P. Light from a subject enters the lens sections 21 via the optical lens system described above.

Each color filter 25 is configured to cause light in a specific wavelength region of incident light to selectively penetrate. Each of the pixels includes, for example, a photodiode PD as a photoelectric converter. The plurality of pixels P provided in the pixel section 100 of the imaging device 1 include a plurality of pixels Pr, pixels Pg, and pixels Pb, as illustrated in FIG. 3. In the pixel section 100, as the example illustrated in FIG. 3, a plurality of pixels Pr, a plurality of pixels Pg, and a plurality of pixels Pb are repeatedly arranged.

Each pixel Pr is a pixel provided with the color filter 25 that causes light of red (R) to penetrate. The color filter 25 of red causes light in a red wavelength region to penetrate. The photoelectric converter of the pixel Pr receives red wavelength light and performs photoelectric conversion. Further, each pixel Pg is a pixel provided with the color filter 25 that causes light of green (G) to penetrate. The color filter 25 of green causes light in green wavelength region to penetrate. The photoelectric converter of the pixel Pg receives green wavelength light and performs photoelectric conversion.

Each pixel Pb is a pixel provided with the color filter 25 that causes light of blue (B) to penetrate. The color filter 25 of blue causes light in blue wavelength region to penetrate. The photoelectric converter of the pixel Pb receives blue wavelength light and performs photoelectric conversion. The pixel Pr, the pixel Pg, and the pixel Pb respectively generate a pixel signal of R component, a pixel signal of G component, and a pixel signal of B component. This allows the imaging device 1 to obtain pixel signals of R, G, and B.

Note that the filter provided for each of the pixels P is not limited to the color filter of primary color (R, G, or B), and thus may be a color filter of complementary color such as Cy (cyan), Mg (magenta), or Ye (yellow), for example. Further, a color filter corresponding to W (white), that is a filter that causes light in all the wavelength regions of the incident light to penetrate, may be arranged.

In the present embodiment, each of the pixel Pr and the pixel Pb is arranged in a unit of eight pixels, as the example illustrated in FIG. 3. Further, the pixel Pg is arranged in a unit of ten pixels. In the pixel section 100, eight adjacent pixels Pr, ten adjacent pixels Pg, and eight adjacent pixels Pb are repeatedly arranged. A pixel block including the eight pixels Pr, a pixel block including the ten pixels Pg, and a pixel block including the eight pixels Pb are arranged in accordance with a Bayer arrangement.

In the imaging device 1, the lens sections 21 are provided over an entire region of the pixel section 100. In the example illustrated in FIG. 3, as described above, each of the lens sections 21 is provided for each two adjacent pixels P. In the surface of the pixel section 100, each of the lens sections 21 is arranged facing six surrounding lens sections 21. Each of the lens sections 21 is, in the XY plane, arranged adjacent to six surrounding lens sections 21. Further, each of the lens sections 21 has upper sides 22a and 22b, lower sides 22c and 22d, a left side 22e, and a right side 22f, as the example illustrated in FIG. 3.

In the example illustrated in FIG. 3, the two upper sides 22a and 22b, the two lower sides 22c and 22d, the one left side 22e, and the one right side 22f are each a side having a straight-line shape. Each of the left side 22e and the right side 22f has a length shorter than a length of each of the upper sides 22a and 22b. Further, each of the left side 22e and the right side 22f has a length shorter than a length of each of the lower sides 22c and 22d.

In plan view, each of the lens sections 21 has a hexagonal shape. As illustrated in FIG. 3, the lens sections 21 are provided on the whole surface of the pixel section 100, being arranged shifted by one pixel every row of the pixel section 100. In the present embodiment, the lens sections 21 each having a hexagonal shape are provided, and thus generation of a gap between the lens sections 21 in the pixel section 100 is possible to be suppressed, allowing the sensitivity of each of the pixels P to be enhanced.

As illustrated in FIG. 3, one lens section 21 is arranged with respect to two adjacent pixels Pg. In other words, left and right pixels Pg adjacent to each other share one lens section 21. The respective photoelectric converters of the two pixels Pg receive light having passed through regions different from each other of the optical lens system and perform pupil division. Thus, with use of a pixel signal based on a charge photoelectrically converted in the photoelectric converter of one of the two pixels Pg and a pixel signal based on a charge photoelectrically converted in the photoelectric converter of the other one of the two pixels Pg, phase difference data (phase difference information) is possible to be obtained. With use of the phase difference data, phase difference auto focus (AF) is possible to be performed.

Further, as illustrated in FIG. 3, one lens section 21 is arranged with respect to two pixels Pr. In other words, left and right pixels Pr adjacent to each other share one lens section 21. The respective photoelectric converters of the two pixels Pr receive light having passed through regions different from each other of the optical lens system and perform pupil division. Thus, with use of pixel signals output from the pixels Pr, phase difference data is possible to be obtained, allowing phase difference AF to be performed. Further, one lens section 21 is arranged with respect to two pixels Pb. Thus, with use of pixel signals output from the pixels Pb, phase difference data is possible to be obtained, allowing phase difference AF to be performed.

In the imaging device 1, for example, for each plurality of pixels of the same color, a readout circuit is provided. The readout circuit includes an amplification transistor, a reset transistor, and the like. The readout circuit is configured to output a pixel signal based on a charge photoelectrically converted in the photoelectric converter. For example, for each pixel block described above, the readout circuit is provided. Eight adjacent pixels Pr share one readout circuit. Further, ten adjacent pixels Pg share one readout circuit and eight adjacent pixels Pb share one readout circuit. The readout circuit is operated in a time division manner, and thereby a pixel signal of each of the pixels is read. Further, a pixel signal obtained by adding signals of the pixels is also possible to be read. Note that, for each two pixels P sharing the lens section 21, the readout circuit may be provided. Further, for each pixel P, the readout circuit may be provided.

Each of the pixel Pr, pixel Pg, and pixel Pb is also a phase difference pixel that is possible to output a signal to be used for phase difference detection. In the imaging device 1 according to the present embodiment, the phase difference pixel is repeatedly provided on a whole surface of an imaging surface of the imaging device 1, that is the entire pixel section 100. This makes it possible to obtain phase difference data over the whole surface of the imaging surface of the imaging device 1, allowing auto focus with high precision to be performed. This allows image quality of an image to be enhanced.

Further, signal processing is performed with respect to pixel signals output from the respective pixels of pixel Pr, pixel Pg, and pixel Pb, and thus image data is possible to be generated. In this case, for example, with use of a signal obtained by adding signals of pixels of the same color sharing the lens section 21, the image data may be generated. The image data may be generated on the basis of a signal obtained by adding signals of pixels of a pixel block. With the imaging device 1 according to the present embodiment, a pixel signal for image generation is possible to be obtained over the whole surface of the imaging surface, allowing deterioration in image quality to be suppressed.

### [Configuration of Pixel]

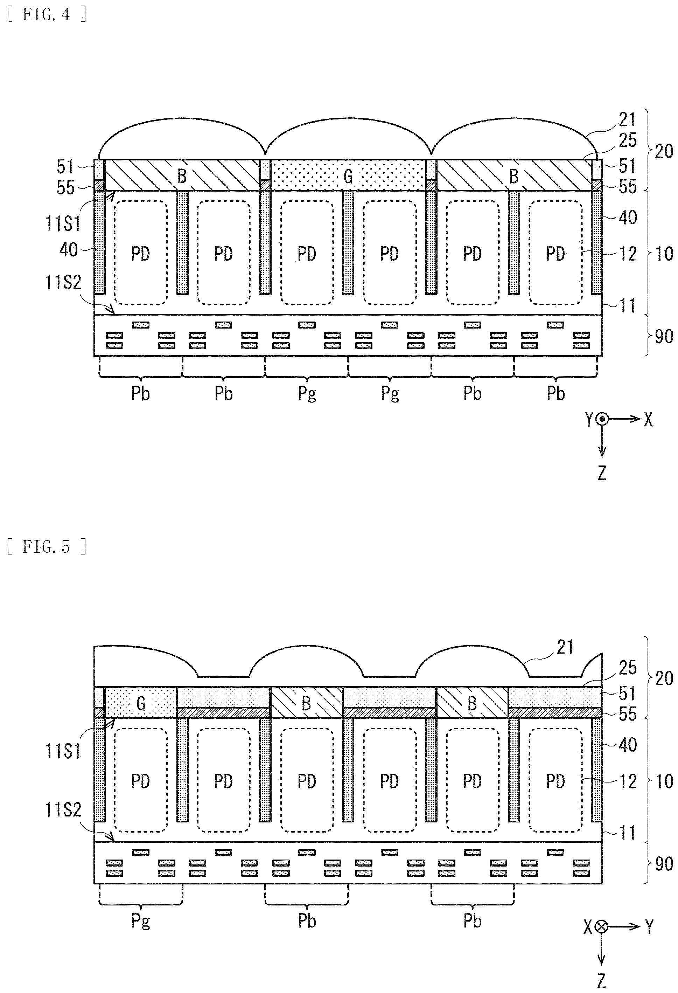

FIGs. 4 and 5 are each a diagram illustrating an example of a cross-sectional configuration of the imaging device according to the embodiment. FIG. 4 illustrates an example of a cross-sectional configuration in a direction of I-I line indicated in FIG. 3. FIG. 5 illustrates an example of a cross-sectional configuration in a direction of II-II line indicated in FIG. 3. The imaging device 1 has a configuration in which a light receiving section 10, a light guiding section 20, and a multilayer wiring layer 90 are stacked in the Z axis direction.

The light receiving section 10 includes the semiconductor substrate 11 including a first surface 11S1 and a second surface 11 S2 opposed to each other. The light guiding section 20 is provided on the first surface 11S1 side of the semiconductor substrate 11. The multilayer wiring layer 90 is provided on the second surface 11S2 side of the semiconductor substrate 11. In other words, the light guiding section 20 is provided on a side that light from the optical lens system enters and the multilayer wiring layer 90 is provided on a side opposite to the side that the light enters. The imaging device 1 is a so called back-illuminated imaging device.

The semiconductor substrate 11 includes, for example, a silicon substrate. Photoelectric converters 12 are photodiodes (PDs). Each of the photoelectric converters 12 has a p-n junction in a predetermined region of the semiconductor substrate 11. The semiconductor substrate 11 includes a plurality of the photoelectric converters 12 formed in buried manner. In the light receiving section 10, along the first surface 11S1 and the second surface 11S2 of the semiconductor substrate 11, the plurality of photoelectric converters 12 is provided.

The multilayer wiring layer 90 has a configuration in which a plurality of wiring layers is stacked interposing an interlayer insulating layer, for example. The wiring layers in the multilayer wiring layer 90 are formed using, for example, aluminum (Al), copper (Cu), or tungsten (W). Alternatively, the wiring layers may be formed using polysilicon (Poly-Si). For example, the interlayer insulating layer includes a single layer film formed of one type out of silicon oxide (SiOx), silicon nitride (SiNx), silicon oxynitride (SiOxNy), and the like, or a laminated film formed of two or more types out of them.

The semiconductor substrate 11 and the multilayer wiring layer 90 are provided with a readout circuit including an amplification transistor, a reset transistor, and the like formed. Further, the semiconductor substrate 11 and the multilayer wiring layer 90 are provided with, for example, the vertical drive section 111, the signal processor 112, the horizontal drive section 113, the output section 114, the imaging controller 115, and the input/output terminal 116 described above formed.

The light guiding section 20 includes the lens sections 21 and the color filters 25 described above. Each of the lens sections 21 is arranged over the photoelectric converters 12 of two adjacent pixels P. Each of the lens sections 21 is formed covering two photoelectric converters 12. A width of each of the lens sections 21 is wider than a pixel pitch (pixel interval), in a direction orthogonal to a stacking direction of the lens sections 21 and the photoelectric converters 12. The width of each of the lens sections 21 is wider than a width of each of the photoelectric converters 12, in the X axis direction and Y axis direction.

The light guiding section 20 is stacked on the light receiving section 10, in a thickness direction orthogonal to the first surface 11S1 of the semiconductor substrate 11. The light guiding section 20 guides light entered from above to the light receiving section 10 side. The photoelectric converters 12 photoelectrically convert the light entered via the lens sections 21 and the color filters 25. Further, as illustrated in FIG. 4, the imaging device 1 is provided with partitions 40, light guiding members 51, and light shields 55.

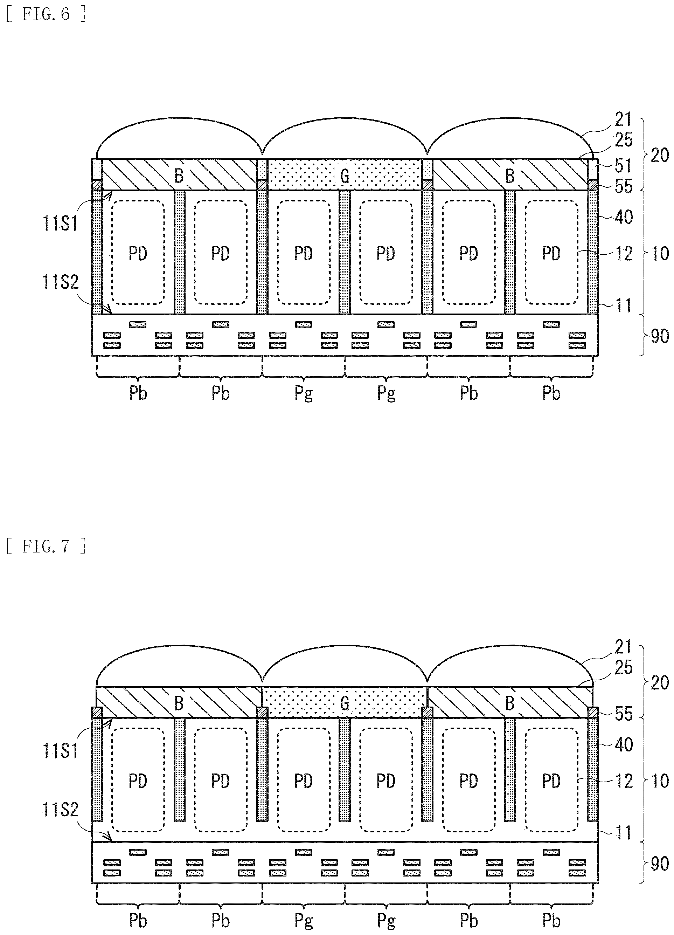

Each partition 40 is provided between adjacent photoelectric converters 12. The partition 40 separates the adjacent photoelectric converters 12. The partition 40, which has a trench structure being provided at a boundary between adjacent pixels P, is also referred to as an inter-pixel partition or an inter-pixel separation wall. Note that, as illustrated in FIG. 6, the partition 40 may be formed reaching the second surface 11S2 of the semiconductor substrate 11.

Each light guiding member 51 has a refraction index lower than a refraction index of surrounding medium. The light guiding member 51 includes, for example, an oxide film, a cavity (gap), and the like. The light guiding member 51, which is a light guiding section, changes a traveling direction of incident light by a refractive index difference between the light guiding member 51 and the surrounding medium. In other words, the imaging device 1 has a waveguide structure that light is guided by the light guiding member 51.

Each light shield 55 includes a member that blocks light and is provided at a boundary between adjacent pixels P. The light shield 55 includes, for example, a metal material (for example, aluminum (Al), copper (Cu), or the like) that blocks light. In the examples illustrated in FIGs. 4 and 5, the light shield 55 is located between adjacent color filters 25 and prevents light from leaking into surrounding pixels. Note that the light shield 55 may include a material that absorbs light.

In the imaging device 1, with the light guiding member 51 and the light shield 55 provided, light is possible to be prevented from leaking into surrounding pixels, allowing mixing of colors to be suppressed. The light guiding member 51 and the light shield 55 may be also referred to as inter-pixel light shielding walls. Further, the light guiding member 51 is possible to propagate incident light to the photoelectric converter 12 side, allowing the sensitivity with respect to the incident light to be enhanced.

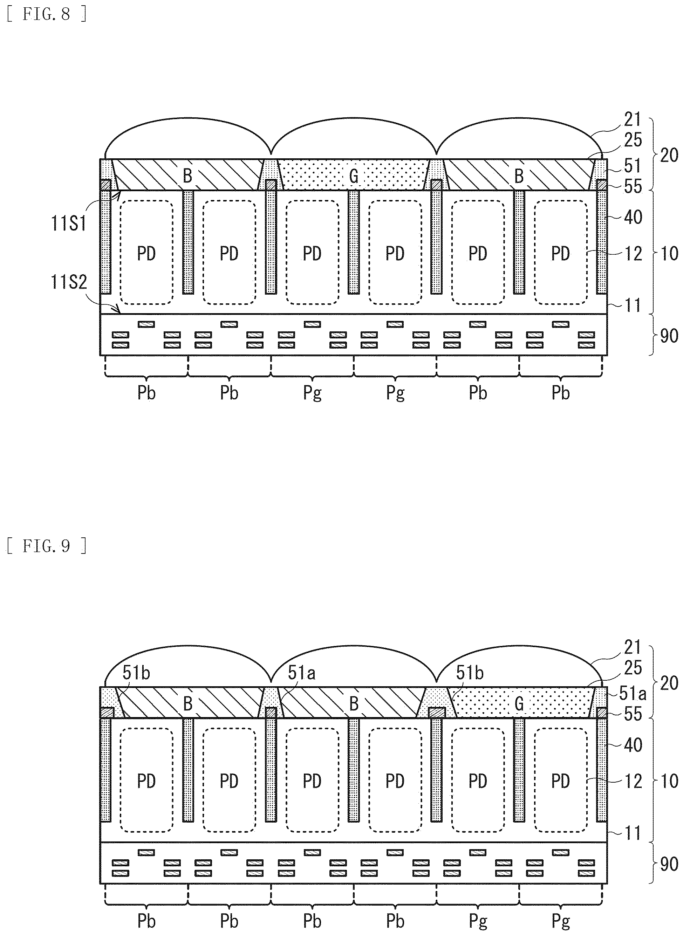

Note that, although a configuration example of the imaging device 1 is described above, this is only an example, and that a configuration of the imaging device 1 is not limited to the example described above. For example, as illustrated in FIG. 7, only the light shield 55 may be arranged and no light guiding member 51 may be arranged. Further, the shape of the light guiding member 51 is not limited particularly. For example, as illustrated in FIG. 8, the closer to the photoelectric converter 12 side, the wider the width of the light guiding member 51 may be.

Further, for example, as illustrated in FIG. 9, a light guiding member 51b relatively thick may be arranged between different color pixels for mixing of colors to be reduced and a light guiding member 51a relatively thin may be arranged between same color pixels. The light guiding member 51b has a width wider than a width of the light guiding member 51a. In the example illustrated in FIG. 9, between a pixel Pb and a pixel Pg, the light guiding member 5 1b is provided. This makes it possible to suppress mixing of colors, allowing generation of a difference in characteristic (for example, sensitivity) between pixels to be suppressed. For example, between same color pixels in a pixel block, it is possible to prevent a difference in characteristic of pixel from being generated.

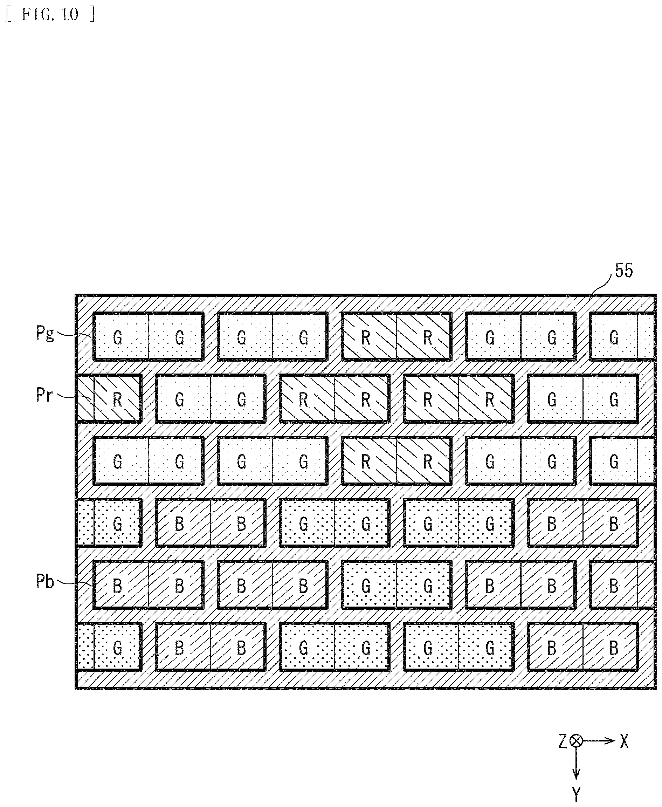

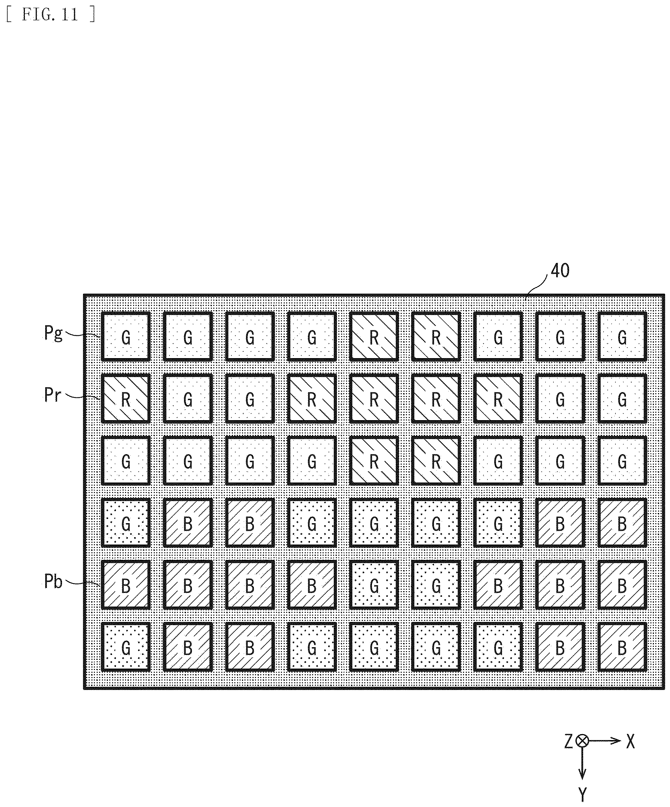

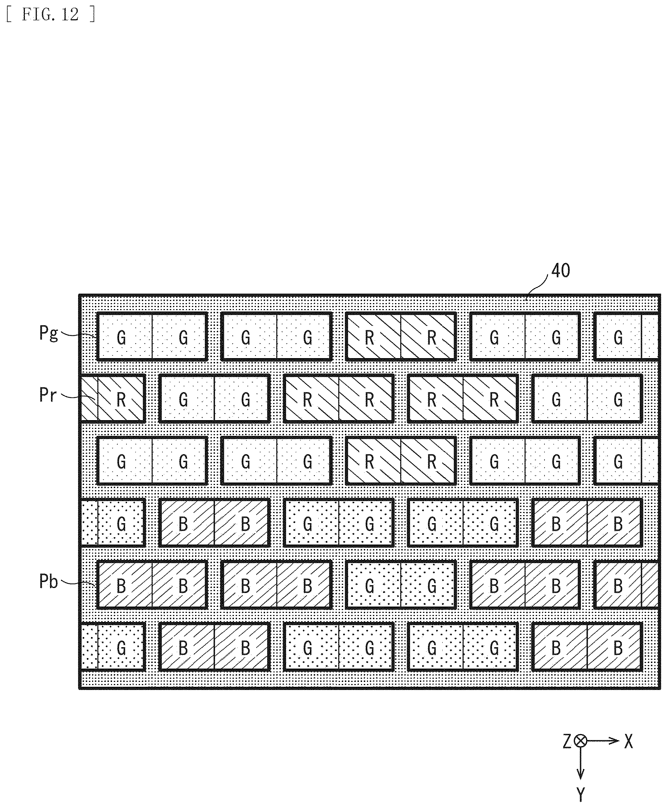

As an example illustrated in FIG. 10, the light shield 55 and the light guiding member 51 surrounding two adjacent pixels P may be provided being arranged shifted by one pixel every row of the pixel section 100. Further, as illustrated in FIG. 11, the partition 40 may be provided surrounding each of the pixels P. Further, as an example illustrated in FIG. 12, the partition 40 surrounding two adjacent pixels P may be provided being arranged shifted by one pixel every row of the pixel section 100.

Note that the imaging device 1 may include, between the color filters 25 and the photoelectric converters 12, an antireflective film and a fixed charge film. The fixed charge film, which is a film having a fixed charge, suppresses generation of a dark current in an interface of the semiconductor substrate 11. The light guiding section 20 described above may include the antireflective film and the fixed charge film.

### [Operations and Effects]

The imaging device 1 according to the present embodiment includes: a light receiving section (light receiving section 10) provided with a plurality of pixels including photoelectric converters (photoelectric converters 12) that photoelectrically convert light; and a plurality of lenses (lens sections 21) provided on a whole surface of the light receiving section. Each of the plurality of lenses is provided with respect to at least two of the plurality of pixels and faces four of the plurality of lenses.

In the imaging device 1 according to the present embodiment, the lens sections 21 are provided on the whole surface of the light receiving section 10, each of the lens sections 21 provided for at least each two of the pixels P. This makes it possible to suppress generation of a difference in characteristic between pixels, as compared with a case where lens sections are provided unevenly on the whole surface of the light receiving section 10.

In a case where a shared on-chip lens is provided in place of a part of the on-chip lenses each provided for the respective pixels, the shape of any one of the on-chip lenses may be distorted, causing a difference in characteristic between pixels to be generated between a pixel provided with the shared on-chip lens and a surrounding pixel. In contrast, in the imaging device 1 according to the present embodiment, the lens sections 21 are provided on the whole surface of the light receiving section 10, each of the lens sections 21 provided for at least each two of the pixels P as described above. This makes it possible to prevent a difference in characteristic between pixels due to distortion in shape of an on-chip lens from being generated.

Next, modifications of the present disclosure will be described. Hereinafter, a component similar to that in the embodiments described above is denoted by the same reference sign, and the description of the component is omitted as appropriate.

### <2. Modifications>

### (2-1. Modification 1)

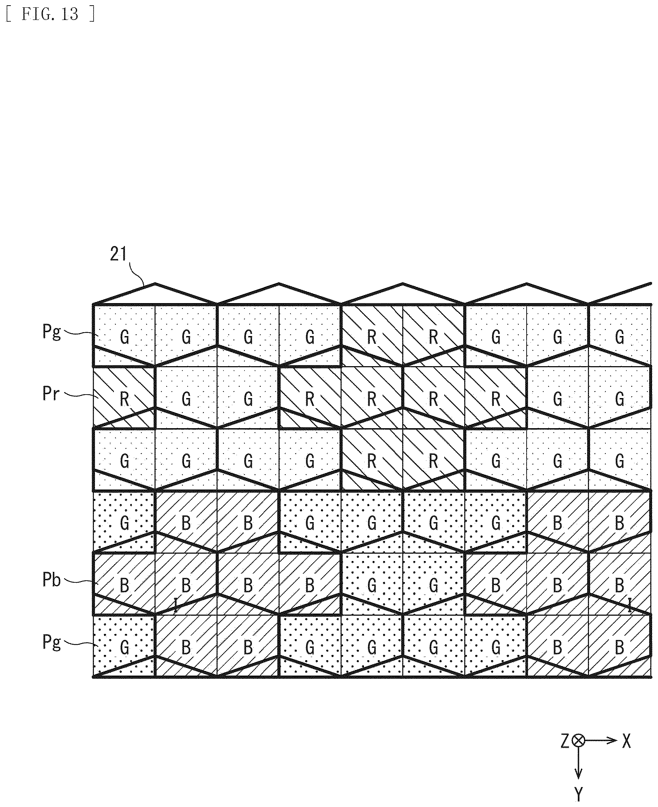

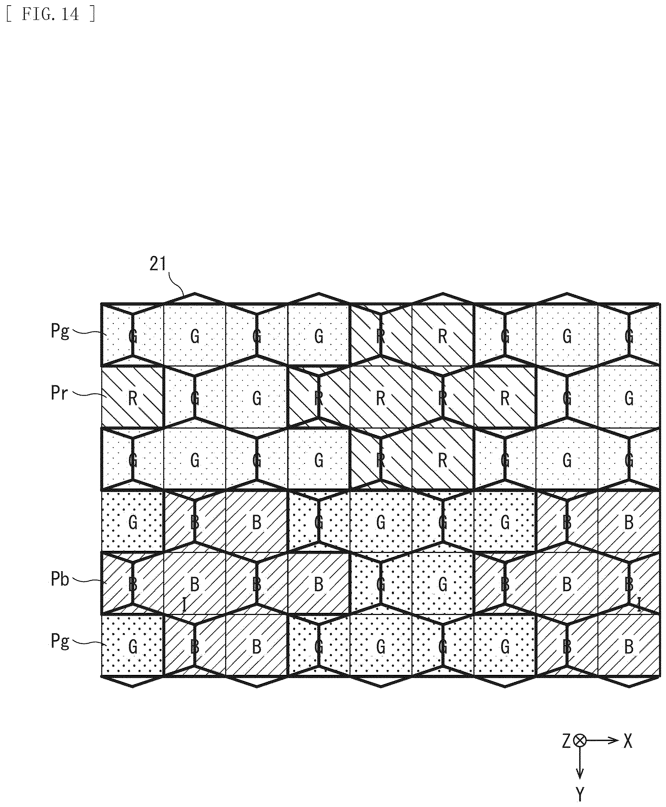

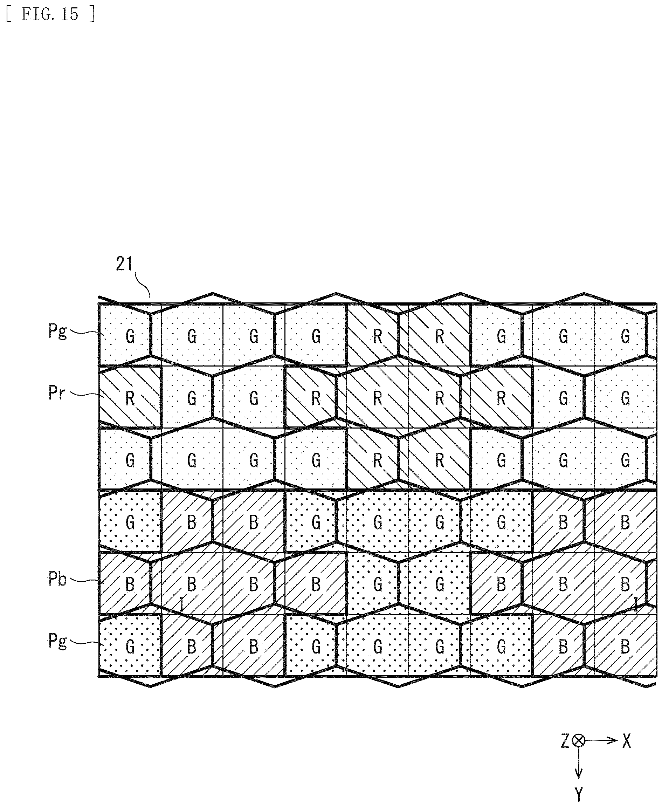

Although an arrangement example of the lens sections 21 is described in the embodiments described above, the arrangement of the lens sections 21 is not limited to this. As illustrated in FIG. 13, each of the lens sections 21 may be arranged over four of the pixels P. Further, for example, each lens section 21 may be arranged over five of the pixels P as illustrated in FIG. 14 or may be arranged over seven of the pixels P as illustrated in FIG. 15.

### (2-2. Modification 2)

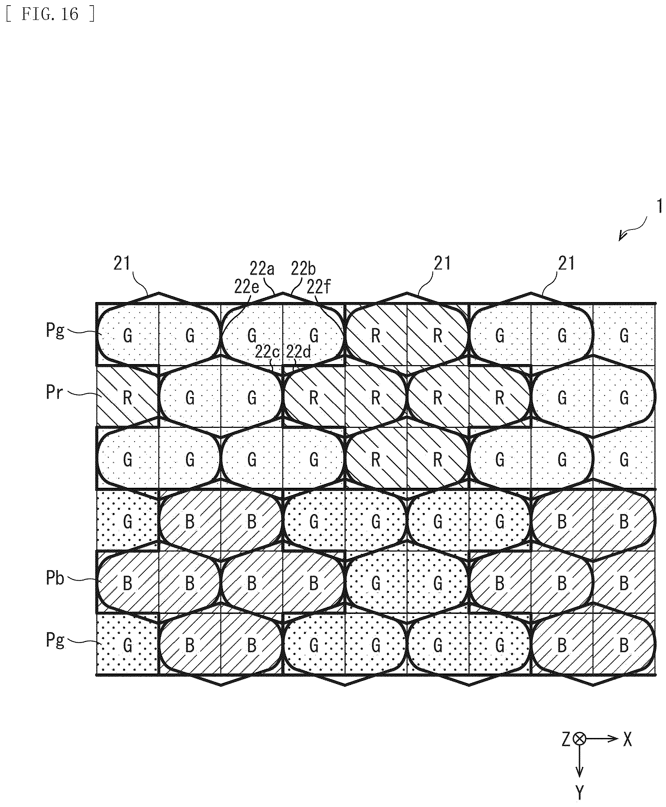

The shape of each lens section 21 is not limited to the example described above. For example, as illustrated in FIG. 16, a side of a portion of the lens section 21 may be curved. In the example illustrated in FIG. 16, a left side 22e and a right side 22f of the lens section 21 are curved. Further, the lens section 21 may have a quadrangular shape or may have another shape.

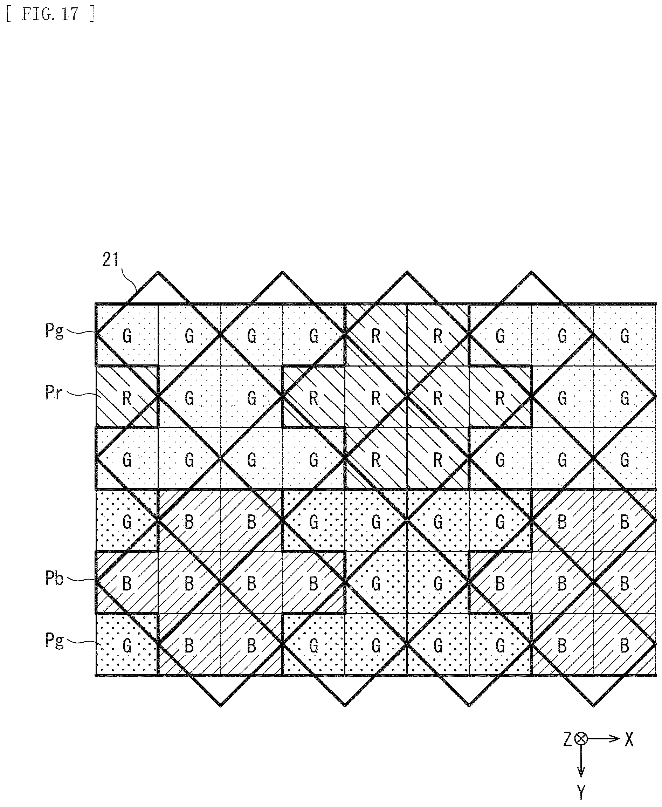

In the example illustrated in FIG. 17, each lens section 21 has a quadrangular shape and is arranged, in the surface of the pixel section 100, facing other four lens sections 21. Each lens section 21 is, in the XY plane, arranged adjacent to four surrounding lens sections 21. The lens sections 21 are arranged in a diagonal direction different from the arrangement direction of the pixels P. As an example, each lens section 21 is, in plan view, arranged being shifted by 45° with respect to the shape of each of the pixels.

### (2-3. Modification 3)

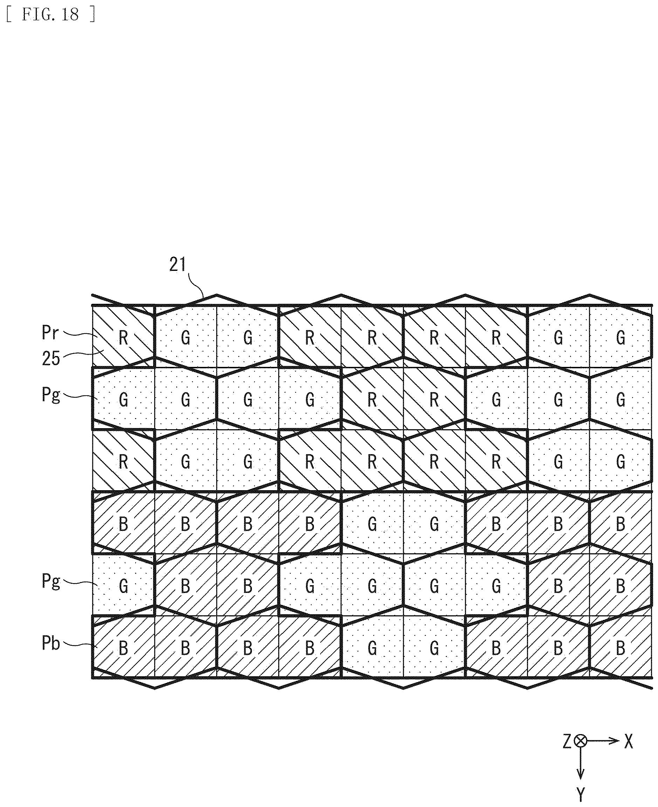

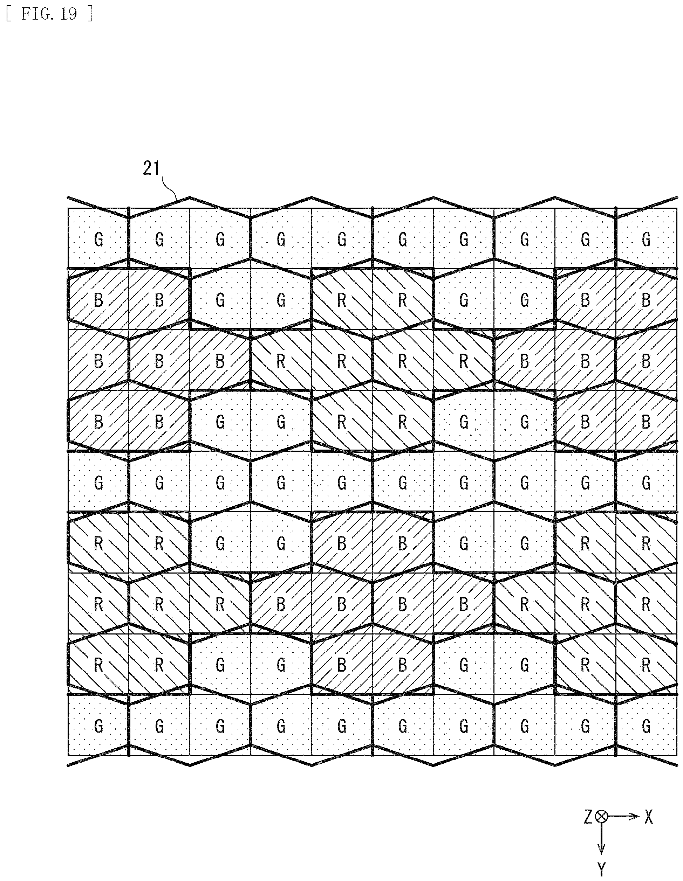

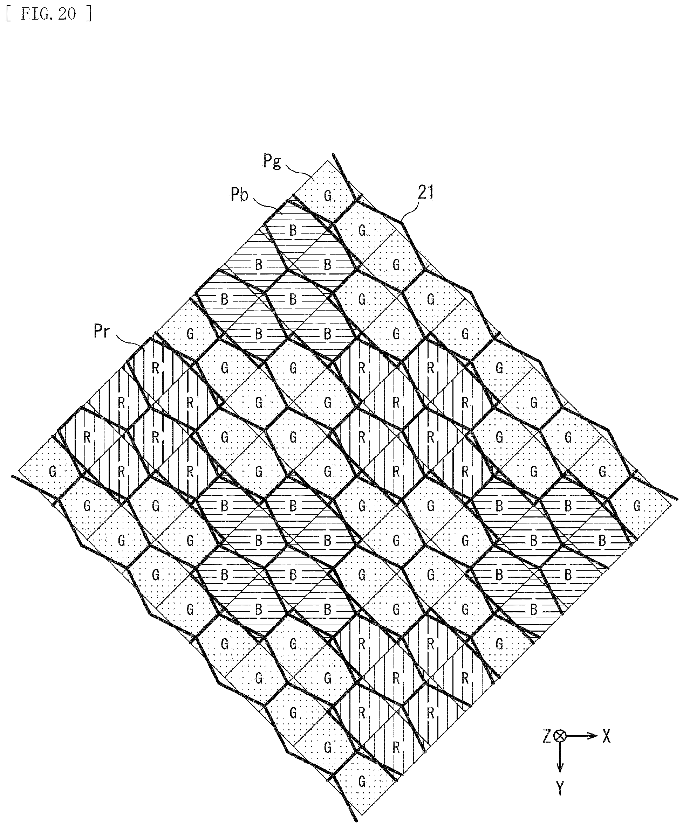

Although an arrangement example of the pixels is described in the embodiments described above, the arrangement of the pixels is not limited to this. As an example illustrated in FIG. 18, the pixel Pg may be provided in a unit of eight pixels. In the example illustrated in FIG. 18, each of the pixel Pr and the pixel Pb is arranged in a unit of ten pixels. Further, as illustrated in FIG. 19, each of the pixel Pr, pixel Pg, and pixel Pb may be provided in a unit of eight pixels. Moreover, as illustrated in FIG. 20, in the pixel section 100, each of the pixel Pr, pixel Pg, and pixel Pb may be arranged being shifted by 45° with respect to the X axis direction and Y axis direction.

### (2-4. Modification 4)

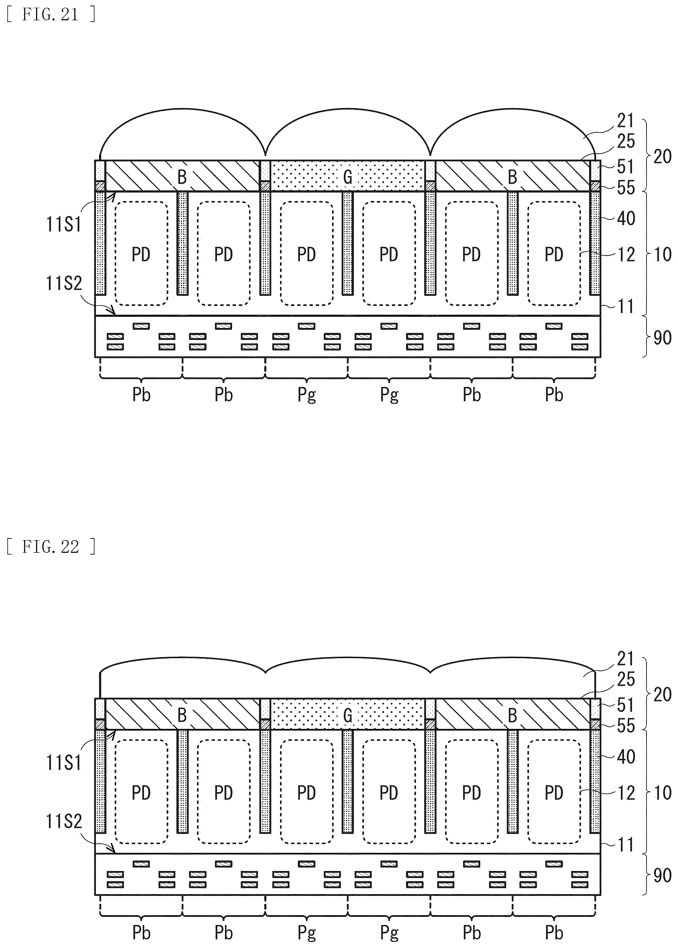

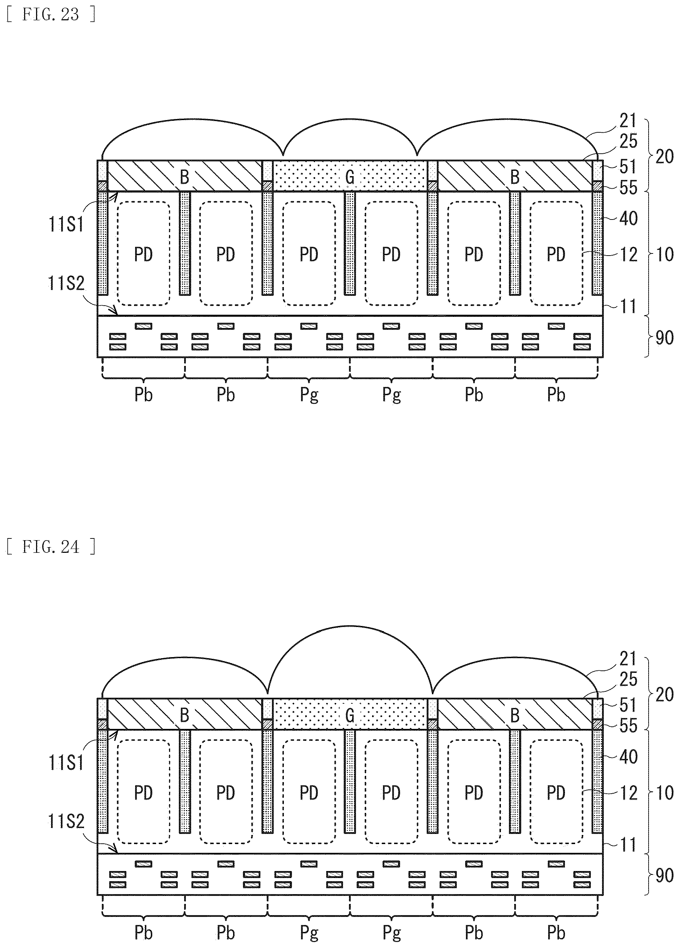

The shape of each of the lens sections 21 on the pixels P may be different depending on a distance from the center of the pixel section 100 (light receiving section 10), that is an image height. In this case, for example, the curvature of each lens section 21 may be adjusted in accordance with the image height. The height, width, and the like of each lens section 21 may be adjusted to change the curvature of the lens section 21. As an example, in a region with a low image height, the lens section 21 is formed with a large curvature as illustrated in FIG. 21. In a region with a high image height, the lens section 21 is formed with a small curvature as illustrated in FIG. 22. Note that, as examples illustrated in FIGs. 23 and 24, the lens sections 21 with different curvatures may be provided for the respective colors of pixels P. With the curvature of each lens section 21 adjusted, it is possible to appropriately perform pupil correction, allowing reduction in sensitivity with respect to the incident light to be prevented.

### <3. Examples of Application>

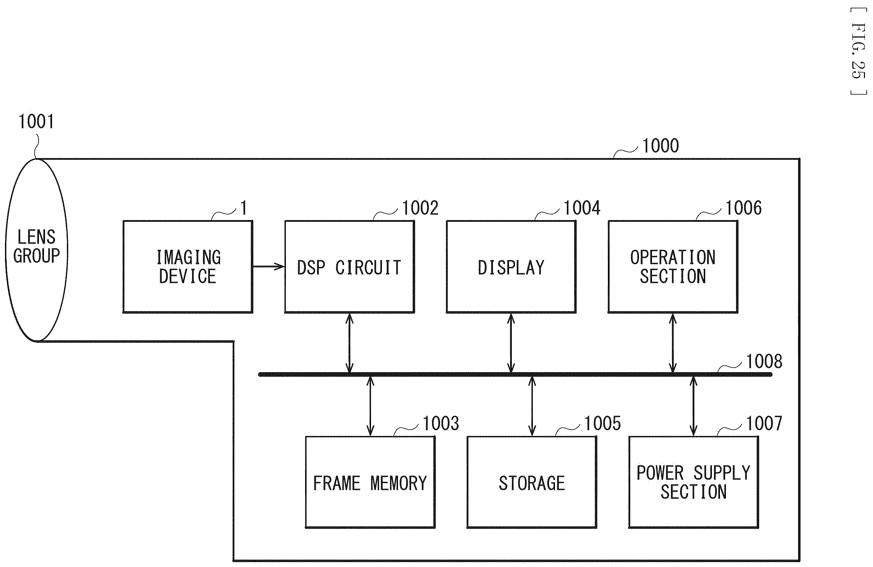

The imaging device 1 and the like described above are possible to be applied to, for example, variety of types of electronic apparatuses provided with an imaging function, such as a camera system such as a digital still camera or a video camera, or a mobile phone having an imaging function. FIG. 25 illustrates a schematic configuration of an electronic apparatus 1000.

The electronic apparatus 1000 includes, for example, a lens group 1001, the imaging device 1, a digital signal processor (DSP) circuit 1002, a frame memory 1003, a display 1004, a recording section 1005, an operation section 1006, and a power supply section 1007, which are interconnected via a bus line 1008.

The lens group 1001 captures incident light (image light) from a subject and forms an image on an imaging surface of the imaging device 1. The imaging device 1 converts the amount of incident light formed into an image on the imaging surface by the lens group 1001 into an electric signal on a pixel-by-pixel basis and supplies the electric signal as a pixel signal to the DSP circuit 1002.

The DSP circuit 1002 is a signal processing circuit that performs processing on a signal supplied from the imaging device 1. The DSP circuit 1002 outputs image data obtained by performing processing on a signal from the imaging device 1. The frame memory 1003 temporarily holds image data processed by the DSP circuit 1002, in frame units.

The display 1004 includes, for example, a panel-type display device such as a liquid crystal panel or an organic electro luminescence (EL) panel, and records, in a recording medium such as a semiconductor memory or a hard disk, image data of a moving image or a still image captured by the imaging device 1.

The operation section 1006 outputs operation signals for various functions owned by the electronic apparatus 1000, in accordance with an operation performed by a user. The power supply section 1007 appropriately supplies various power supplies, which are operation power supplies for the DSP circuit 1002, the frame memory 1003, the display 1004, the recording section 1005, and the operation section 1006, to the respective power supply targets of these.

### <4. Applications>

### (Application to Mobile Object)

The technology according to the present disclosure (the present technology) is possible to be applied to various products. For example, the technology according to the present disclosure may be implemented as a device to be mounted on any type of mobile objects such as vehicles, electric vehicles, hybrid electric vehicles, motorcycles, bicycles, personal mobilities, airplanes, drones, ships, or robots.

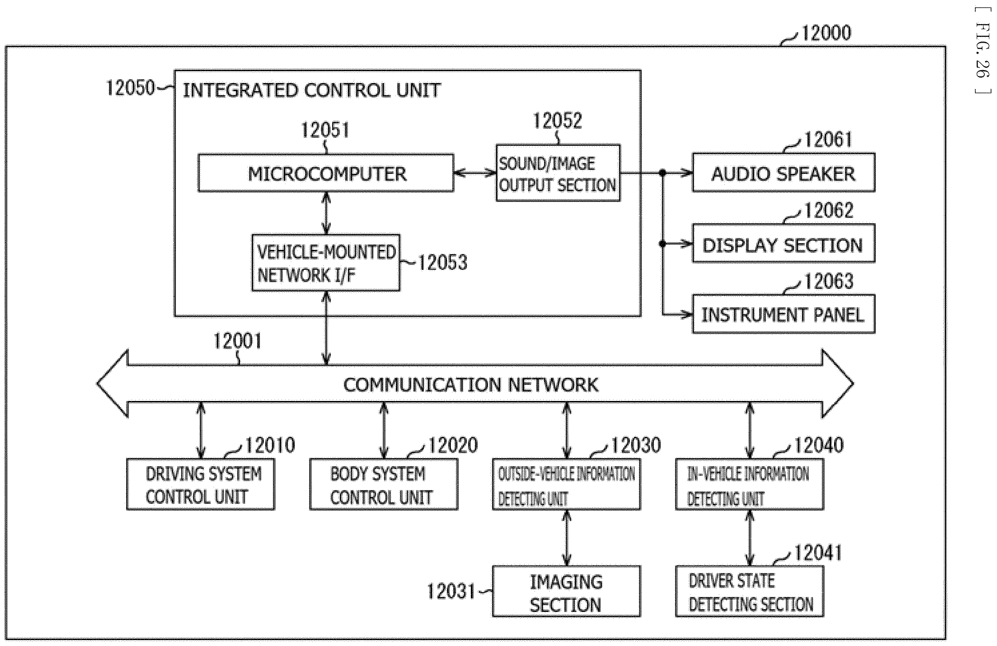

FIG. 26 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 26, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 26, an audio speaker 12061, a display section 12062, and an instrument panel 12063 are illustrated as the output device. The display section 12062 may, for example, include at least one of an on-board display and a head-up display.

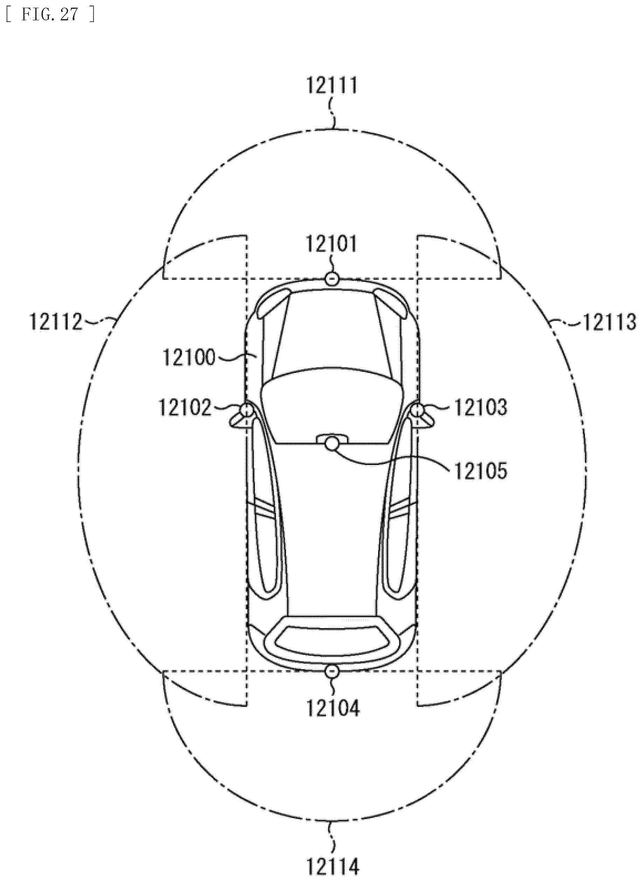

FIG. 27 is a diagram depicting an example of the installation position of the imaging section 12031.

In FIG. 27, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 27 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the mobile body control system to which the technology according to the present disclosure can be applied has been described above. The technology according to the present disclosure may be applied to, for example, the imaging section 12031 in the configuration described above. Specifically, for example, the imaging device 1 or the like can be applied to the imaging section 12031. Applying the technology according to the present disclosure to the imaging section 12031 allows a captured image in high definition to be obtained and control with high accuracy using the captured image to be performed in the mobile body control system.

### (Application to Endoscopic Surgery System)

The technology according to the present disclosure (the present technology) can be applied to various products. For example, the technology according to the present disclosure may be applied to an endoscopic surgery system.

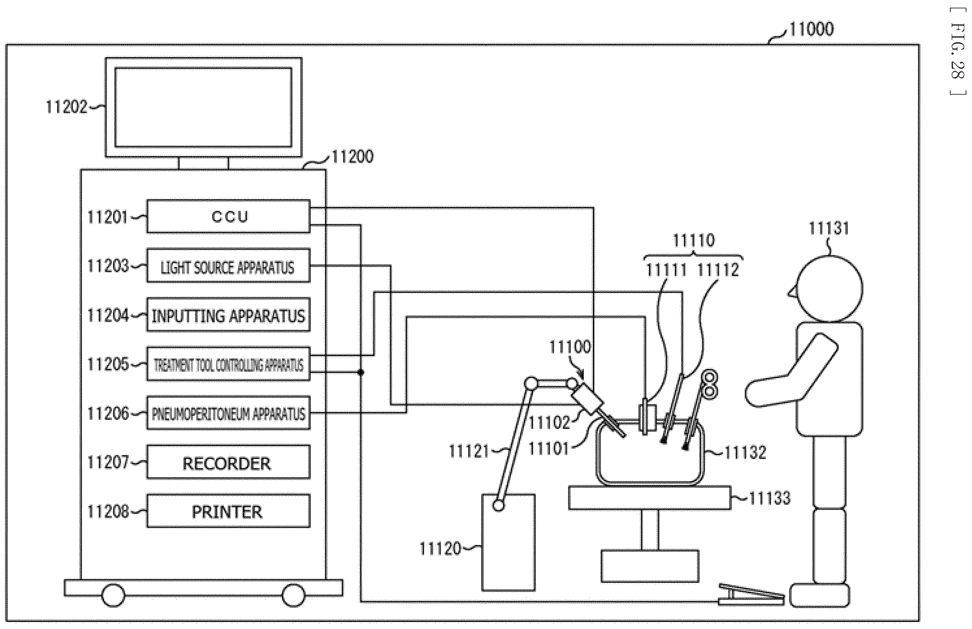

FIG. 28 is a view depicting an example of a schematic configuration of an endoscopic surgery system to which the technology according to an embodiment of the present disclosure (present technology) can be applied.

In FIG. 28, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photo-electrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

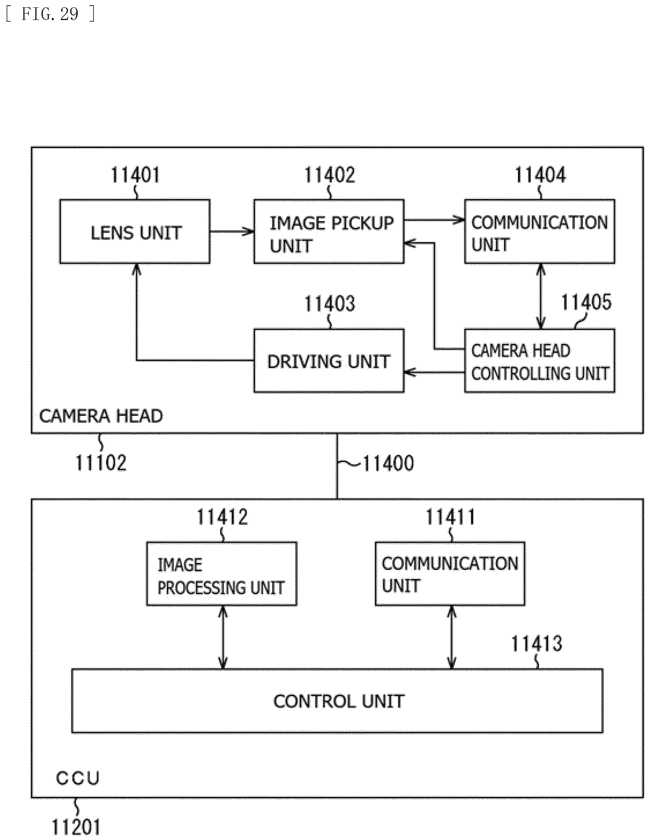

FIG. 29 is a block diagram depicting an example of a functional configuration of the camera head 11102 and the CCU 11201 depicted in FIG. 28.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

One example of the endoscopic surgery system to which the technology according to the present disclosure can be applied has been described above. The technology according to the present disclosure can be suitably applied to, for example, the image pickup unit 11402 provided in the camera head 11102 of the endoscope 11100, among the above-described configurations. Applying the technology according to the present disclosure to the image pickup unit 11402 allows the image pickup unit 11402 to be with high sensitivity, providing the endoscope 11100 with high definition.

While the present disclosure has been described above providing the embodiments, the modifications and the examples of application, and the applications, the present technology is not limited to the embodiments or the like described above, and various modifications are possible. For example, although the modifications described above has been described as a modification of the embodiment described above, the configuration of each modification can be combined as appropriate. For example, the present disclosure is not limited to a back-illuminated image sensor but applicable to a front-illuminated image sensor.

An imaging device according to an embodiment of the present disclosure includes: a light receiving section provided with a plurality of pixels including photoelectric converters that photoelectrically convert light; and a plurality of lenses provided on a whole surface of the light receiving section. Each of the plurality of lenses is provided with respect to at least two of the plurality of pixels and faces four of the plurality of lenses. This allows a difference in characteristic between pixels to be suppressed.

Note that the effect described herein is only an example, which is not limited. Another effect may be present. Further, the present disclosure is possible to take configurations as below.
(1) An imaging device including:
   a light receiving section provided with a plurality of pixels including photoelectric converters that photoelectrically convert light; and
   a plurality of lenses provided on a whole surface of the light receiving section,
   in which each of the plurality of lenses is provided with respect to at least two of the plurality of pixels and faces four of the plurality of lenses.
(2) The imaging device according to (1), in which
   the lens is, in plan view, provided over at least two of the photoelectric converters.
(3) The imaging device according to (1) or (2), in which
   the lens includes, in plan view, two upper sides, two lower sides, one left side, and one right side.
(4) The imaging device according to any one of (1) to (3), in which
   the two upper sides and the two lower sides are each straight.
(5) The imaging device according to any one of (1) to (4), in which
   each of the one left side and the one right side has a length shorter than a length of each of the two upper sides, and
   each of the one left side and the one right side has a length shorter than a length of each of the two lower sides.
(6) The imaging device according to any one of (1) to (3), in which
   the one left side and the one right side are each curved.
(7) The imaging device according to (1) or (2), in which
   the lens has a quadrangular shape in plan view.
(8) The imaging device according to (7), in which
   the plurality of lenses is arranged in a direction different from an arrangement direction of the pixels.
(9) The imaging device according to any one of (1) to (5), in which
   each of the plurality of lenses is provided facing six of the plurality of lenses.
(10) The imaging device according to any one of (1) to (5), in which
   the lens has a hexagonal shape in plan view.
(11) The imaging device according to any one of (1) to (5), in which
   the lens is provided over four of the plurality of pixels.
(12) The imaging device according to any one of (1) to (5), in which
   the lens is provided over five of the plurality of pixels.
(13) The imaging device according to any one of (1) to (5), in which
   the lens is provided over six of the plurality of pixels.
(14) The imaging device according to any one of (1) to (5), in which
   the lens is provided over seven of the plurality of pixels.
(15) The imaging device according to any one of (1) to (14), in which
   in a direction orthogonal to a stacking direction of the lens and the photoelectric converter that photoelectrically converts light having penetrated the lens, the lens has a width wider than a pixel pitch.
(16) The imaging device according to any one of (1) to (15), in which
   in a direction orthogonal to a stacking direction of the lens and the photoelectric converter that photoelectrically converts light having penetrated the lens, the lens has a width wider than a width of the photoelectric converter.

The present application claims the benefit of Japanese Priority Patent Application JP2022-030429 filed with the Japan Patent Office on February 28, 2022, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. An imaging device comprising:
a light receiving section provided with a plurality of pixels including photoelectric converters that photoelectrically convert light; and
a plurality of lenses provided on a whole surface of the light receiving section,
wherein each of the plurality of lenses is provided with respect to at least two of the plurality of pixels and faces four of the plurality of lenses.

2. The imaging device according to claim 1, wherein
the lens is, in plan view, provided over at least two of the photoelectric converters.

3. The imaging device according to claim 1, wherein
the lens includes, in plan view, two upper sides, two lower sides, one left side, and one right side.

4. The imaging device according to claim 3, wherein
the two upper sides and the two lower sides are each straight.

5. The imaging device according to claim 3, wherein
each of the one left side and the one right side has a length shorter than a length of each of the two upper sides, and
each of the one left side and the one right side has a length shorter than a length of each of the two lower sides.

6. The imaging device according to claim 3, wherein
the one left side and the one right side are each curved.

7. The imaging device according to claim 1, wherein
the lens has a quadrangular shape in plan view.

8. The imaging device according to claim 7, wherein
the plurality of lenses is arranged in a direction different from an arrangement direction of the pixels.

9. The imaging device according to claim 1, wherein
each of the plurality of lenses is provided facing six of the plurality of lenses.

10. The imaging device according to claim 1, wherein
the lens has a hexagonal shape in plan view.

11. The imaging device according to claim 1, wherein
the lens is provided over four of the plurality of pixels.

12. The imaging device according to claim 1, wherein
the lens is provided over five of the plurality of pixels.

13. The imaging device according to claim 1, wherein
the lens is provided over six of the plurality of pixels

14. The imaging device according to claim 1, wherein
the lens is provided over seven of the plurality of pixels.

15. The imaging device according to claim 1, wherein
in a direction orthogonal to a stacking direction of the lens and the photoelectric converter that photoelectrically converts light having penetrated the lens, the lens has a width wider than a pixel pitch.

16. The imaging device according to claim 1, wherein
in a direction orthogonal to a stacking direction of the lens and the photoelectric converter that photoelectrically converts light having penetrated the lens, the lens has a width wider than a width of the photoelectric converter.
